(19) Europäisches Patentamt
European Patent Office
Office européen des brevets

(11) Publication number : 0 443 803 A2

# (12) EUROPEAN PATENT APPLICATION

(21) Application number : 91301288.6

(22) Date of filing : 19.02.91

(51) Int. Cl.$^5$ : G03F 7/20

(30) Priority : 20.02.90 JP 37215/90

(43) Date of publication of application : 28.08.91 Bulletin 91/35

(84) Designated Contracting States : DE FR GB IT NL

(71) Applicant : CANON KABUSHIKI KAISHA
30-2, 3-chome, Shimomaruko, Ohta-ku
Tokyo (JP)

(72) Inventor : Tomono, Haruo, c/o Canon Kabushiki Kaisha
3-30-2 Shimomaruko, Ohta-ku
Tokyo (JP)

(74) Representative : Beresford, Keith Denis Lewis et al
BERESFORD & Co. 2-5 Warwick Court High Holborn
London WC1R 5DJ (GB)

## (54) Dummy wafer.

(57) A dummy wafer usable in a step-and-repeat type semiconductor device manufacturing exposure apparatus, for correction of a system error of the exposure apparatus is disclosed. The dummy wafer includes a substrate to be held by the wafer chuck by attraction ; a first layer formed on the substrate and containing (a) 5 - 80 weight % of organic photochromic material selected out of spiro-pyran derivatives and spironaphthooxazine derivatives, (b) 0.1 - 50 weight % of organic additive, and (c) 20 - 94.9 weight % of polymer ; and a second layer formed on the first layer and having a layer of polymer material with an appropriate transmission rate of oxygen preferably not greater than $1.0 \times 10^{-10}$ $cm^3 \cdot cm/cm^2 \cdot s \cdot cmHg$ ; wherein a mark can be transferred to the first layer with use of an exposure beam used for the pattern printing onto the semiconductor wafer ; and wherein the mark as transferred to the first layer can be observed or detected through the second layer.

EP 0 443 803 A2

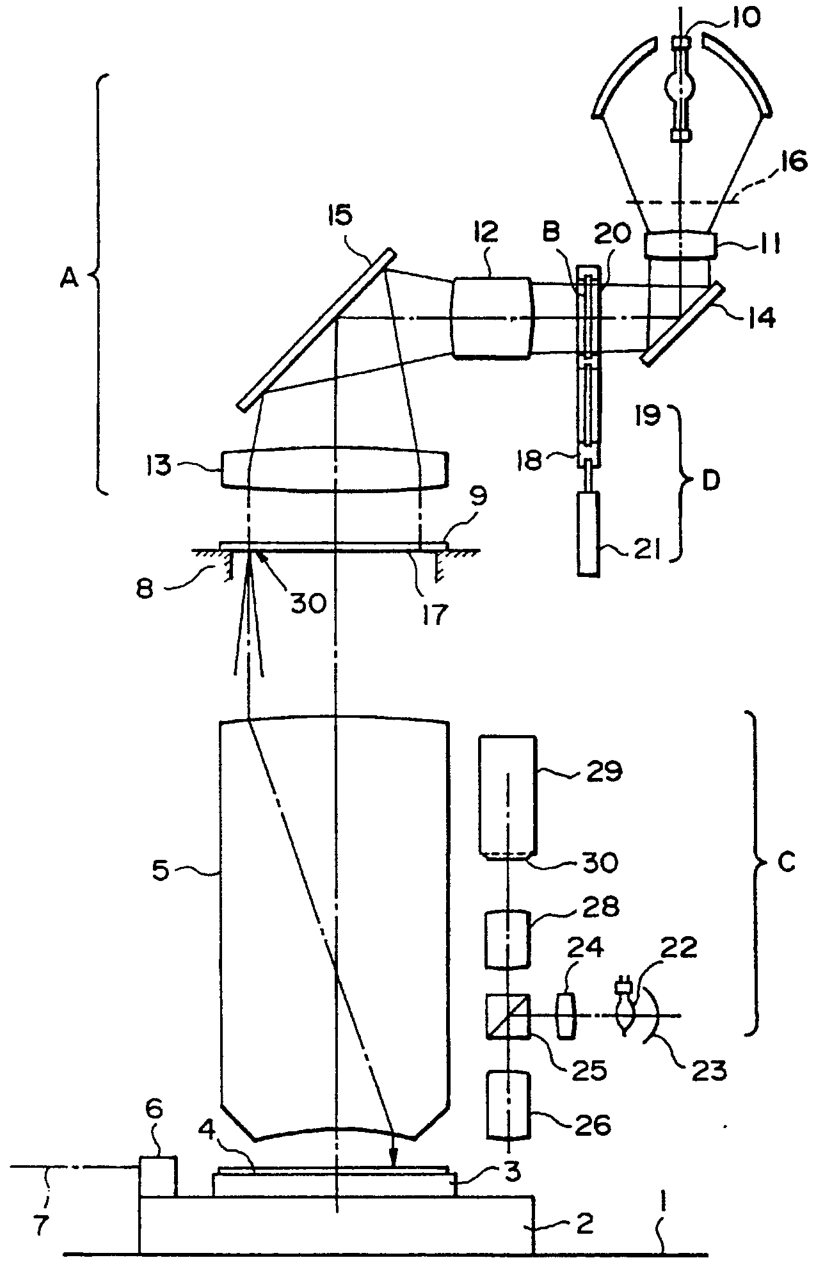

10
16
11
14
15
12
B
20
A
19
D
18
13
21
9
8
30
17
29
30
C
5
28
24
22
25
23
26
6
4
3
7
2
1


F I G. 1

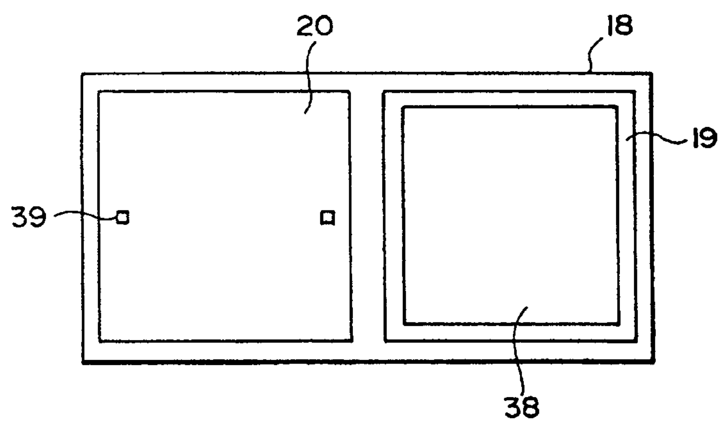

20
18
19
39
38


F I G. 2

# DUMMY WAFER

## FIELD OF THE INVENTION AND RELATED ART

This invention relates to a dummy wafer and a method and manufacture of the same, suitably usable in an apparatus for manufacture of semiconductor devices such as ICs, LSIs and the like, for removing any system error therein.

Conventionally, exposure apparatuses for use in the manufacture of semiconductor devices such as ICs, LSIs and the like are required to have two basic performances, i.e. the performance in respect to resolution and the performance in respect to superposition. The former is an ability of that how fine pattern can be formed on the surface of a photoresist applied to the surface of a semiconductive workpiece (hereinafter "wafer"). The latter is an ability of that how accurately a pattern of a photomask can be aligned with and transferred onto a pattern formed on a wafer in the preceding process.

In terms of an exposure method adopted, exposure-apparatuses can be classified generally into contact exposure apparatuses, proximity exposure apparatuses, mirror projection exposure apparatuses, step-and-repeat exposure apparatuses each being called a "stepper", X-ray aligners and the like. In each of these types, various superposing methods to be considered best have been developed and put into practice.

Generally, as for the manufacture of semiconductor devices, such an exposure method which assures balanced resolution performance and superposition performance is preferable and, in consideration thereof, currently in many cases a reduction projection type exposure apparatuses called a "stepper" is used.

The performance of resolution to be required in a forthcoming exposure apparatus will be about 0.5 micron. As for the exposure system that can acquire this performance, there are three types, i.e., a stepper which uses an excimer laser as a light source, a proximity type aligner which uses X-rays as an exposure energy source and an electron beam direct pattern drawing system. From the viewpoint of productivity, the former two systems are preferred.

On the other hand, as regards the superposing precision, usually such a value which is 1/3 - 1/5 of the minimum printable linewidth is considered to be necessary. To acquire this precision involves, in usual, a difficulty of the same level as or of a higher level than that involved in the acquirement of the resolution performance.

In general, the relative positioning (i.e., alignment) of a pattern on the surface of a reticle and a pattern on the surface of a wafer involves error factors such as follows:

(1.1) With the type or process of the device, a pattern (or a mark) on the surface of a wafer can have a many varieties of cross-sectional shapes, physical properties or optical characteristics.

(1.2) In order to make it sure to attain alignment of a predetermined precision, while confronting the variety in the process, an alignment optical system as well as a signal processing system should have a high degree of freedom.

(1.3) In order to assure a high degree of freedom of the alignment optical system, it is necessary to make the alignment optical system independent of a projection lens to avoid that the performance of the alignment optical system is sacrificed for the enhancement of the performance of the projection lens. This necessarily results in indirectness of the alignment between a reticle and a wafer.

Generally, it is important to reduce these error factors a much as possible and also to make them well balanced.

Particular examples of the above-described error factors will now be explained.

(2.1) By using an alignment light of the same wavelength as the printing wavelength, it is possible to provide what can be called a TTL (through the lens) on-axis alignment system. With such an alignment system, since a projection lens is well aberration corrected with respect to this wavelength, it is possible to dispose the alignment optical system above a reticle, for example. As a result, it is possible to execute the alignment of a pattern of a wafer and a pattern on the surface of a reticle, while observing within the same viewfield a projected image of the wafer pattern and the pattern of the reticle at the same time. Also, at the same site at which the alignment is completed, the exposure can be made. Therefore, this method involves no system error factor.

With this method, however, there is no choice in regard to the wavelength of the alignment light. Additionally, in relation to a process to be adopted, there is such a disadvantage that a signal light from a wafer is extraordinarily attenuated in a process-where an absorptive resist having enhanced absorptiveness to the printing wavelength is used.

(2.2) In an off-axis type stepper, a wafer alignment optical system can be designed freely, without any limitation by a projection lens. Therefore, owing to the high degree of freedom, the potential confronting the

process can be intensified. With this type, however, simultaneous observation of a reticle and a wafer is not attainable. As regards the reticle, in preparation it is brought into alignment with respect to a predetermined reference by using a reticle alignment microscope. As regards the wafer, by using a wafer alignment microscope (hereinafter "wafer microscope"), it is brought into alignment with respect to a reference defined in the microscope. This results in the presence of an error factor between the reticle and the wafer. Additionally, after the wafer alignment, the wafer has to be moved through a predetermined distance (called a "reference length" or "base line") for superposition of a projected image of the reticle on a pattern of the wafer. Accordingly, this type involves increased system error factors.

In an apparatus which adopts such an alignment method that involves system errors as described hereinbefore, it is necessary to take measures to hold these error factors stabilized as well as to check and correct periodically the magnitude of them. As an example, the reference length which corresponds to the distance between the optical axes of a projection lens and an alignment microscope is usually several tens millimeters. Generally, even if strict temperature control is made to suppress the thermal expansion of a material connecting them, there occurs a change with time in the unit of 0.1 - 0.01 micron. Major factors for causing such a change with time are, in addition to the aforementioned reference length, the projection magnification of a lens, the reticle alignment position, the coordinate system of a wafer stage and the like.

In an attempt to providing an exposure apparatus by which system errors such as various error factors in regard to superposition of a reticle and a wafer (for example, any change with time of the magnification of a projection optical system, any change with time of the reference length and any change with time of the coordinate system of an X-Y stage for carrying and moving the wafer) can be well corrected and thus high-precision superposition is ensured stably, proposals have been made in regard to determination of a system error. An example is disclosed in Japanese Laid-Open Patent Application Sho 61-114529. According to this proposal, a dummy wafer may be used. An image of an alignment pattern provided on the surface of a reticle is transferred to a photosensitive material applied to the surface of such a dummy wafer which is placed on a movable stage. Then, the image of the alignment pattern thus formed on the photosensitive material is detected to thereby determine the system error.

More particularly, a pattern on the surface of a reticle is transferred onto the surface of a dummy wafer and, by using a wafer alignment microscope, the transferred image is detected. On the basis of the result of detection, the system error in the exposure apparatus as a whole is corrected automatically or semi-automatically within the apparatus itself.

## SUMMARY OF THE INVENTION

As for the photosensitive material for such a dummy wafer, the following characteristics are required.

(1) For enhancement of the processing speed, it should have a good color developability with respect to ultraviolet light.

(2) To allow automatic correction of the system error by the machine, during the data collection based on exposure to visible light the colored matter should retain contrast not lower than a predetermined level.

(3) It should have sufficient repetition durability.

As for such photosensitive materials which satisfy these conditions (1) - (3), there may be cited examples such as photosensitive resist materials, inorganic photochromic materials and organic photochromic materials.

However, the photosensitive resist materials can not be used repeatedly.

The inorganic photochromic materials do not have a good color developability and, therefore, enhancement in the processing speed is not attainable.

Further, while the organic photochromic materials have a good color developability, decoloration is so quick that, during the data collection based on exposure to visible light, the contrast becomes lower than a required. Moreover, there is much subsidiary reaction in addition to the coloring and decoloring reaction which is the very one aimed at and, therefore, the repetition durability can not be improved.

A proposal has been made in U.S. Patent Application Serial No. 389, 302 filed August 3, 1989 by Naoki Kobayashi and assigned to the same assignee of the subject application, in an attempt to solving these inconveniences involved in a dummy wafer (see Japanese laid Open Specification No 02-056919).

It is an object of the present invention to provide an improved dummy wafer.

In an attempt to accomplishing the above object, particular note has been paid to and various investigations have been made on, by the inventor of the subject application, those organic photochromic materials having better color developability with respect to ultraviolet light, used generally as a light source of a semiconductor exposure apparatus . As a result of the investigations, it has been found that, of various organic photochromic materials, one provided by spiro-pyran derivative or spironaphthooxazine derivative to which organic additive and polymer such as polymeric resin are added, has satisfactory color developability suited for use as a photosensitive material of a dummy wafer.

Additionally, investigations have been made on the cause of failure in attaining enhanced repetition durability, and it has been found that the decomposition of a photochromic material by oxygen is a major factor of it. Also, as a measure to that, it has been found that, when, on a first layer containing a photochromic material, a second layer (polymer layer) having a transmission rate of oxygen not greater than $1.0x10^{-10}$ $cm^3 \cdot cm/cm^2 \cdot s \cdot cmHg$ is overlaid, the repetition durability of the photochromic material can be enhanced significantly.

Thus, a dummy wafer according to an aspect of the present invention comprises:

(i) a first layer which contains:

(a) 5 - 80 weight % of an organic photochromic material selected out of spiro-pyran derivatives or spironaphthooxazine derivatives,

(b) 0.1 - 50 weight % of organic additive, and

(c) 20 - 94.9 weight % of polymer; and

(ii) a second layer made of single or different polymer materials, formed on the first layer and having transmission rate of oxygen not greater than $1.0x10^{-10}$ $cm^3 \cdot cm/cm^2 \cdot s \cdot cmHg$.

As an example of adoptable first-layer forming method, there is a method wherein coating liquid which can be provided by solving an organic photochromic material, organic additive and polymer with organic solvent, is applied to a substrate such as a bare silicon or a silicon wafer having been subjected to vacuum deposition or the like and, then, the substrate is heat-dried to remove the organic solvent contained in the coating liquid.

As an example of adoptable method of forming the second layer to be overlaid on the first layer, there is a method wherein coating liquid which can be provided by solving a resin having a low oxygen transmission rate into a suitable solvent, is applied onto the first layer formed on the substrate and, then, the substrate is heat-dried to increase the adhesion strength of the first and second layers. The solvent to be used here should not be such to which the material of the first layer is soluble. By overcoating the first layer with a resin soluble to such solvent and having a low oxygen transmission rate, the second layer can be formed easily.

Examples of usable organic photochromic material are spiro-pyran derivatives and spironaphthooxazine derivatives. Spiro-pyran derivative may preferably be selected out of those that satisfy a general formula (I') as follows:

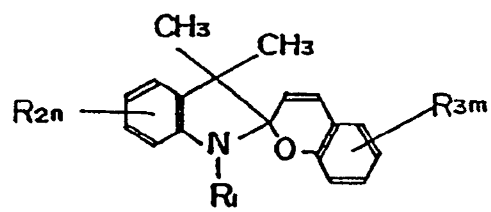

(I')

wherein $R_1$ denotes non-substituted or substituted alkyl group having a number of contained carbon of 1 - 22; $R_2$ and $R_3$ each denotes substituent selected out of hydrogen atom, alkyl group, alkoxyl group, aryl group, hydroxyl group, amino group, halogen group, cyano group, carboxyl group, nitro group and the like; and m and n denote integers in a range of 0 - 5.

Particularly, such derivatives as represented by a general formula (I) with 6'-position substituted by nitro group, have superior color developability:

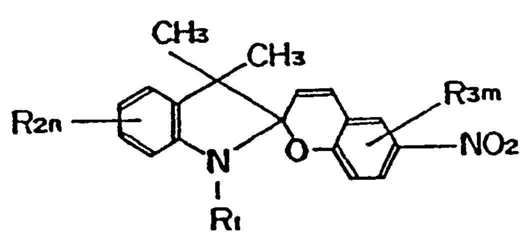

(I)

wherein $R_1$ denotes non-substituted or substituted alkyl group having a number of contained carbon of 1 - 22; $R_2$ and $R_3$ each denotes substituent selected out of hydrogen atom, alkyl group, alkoxyl group, aryl group, hydroxyl group, amino group, halogen group, cyano group, carboxyl group, nitro group and the like; and m and n denote integers in a range of 0 - 4.

More particularly, among of them, 1,3,3-trimethylindolino-6'-nitrobenzopyrylospiran of the following formula

with $R_1$ represented by methyl group and $R_2$ and $R_3$ represented by hydrogen atom:

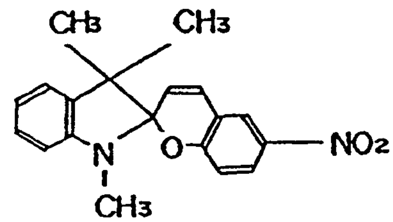

has excellent developability and, additionally, it can be synthesized easily and is available quickly. Thus, the material cost is low and it is preferable.

Spironaphthooxazine derivative may preferably be selected out of those materials that are represented by general formula (II) as follows:

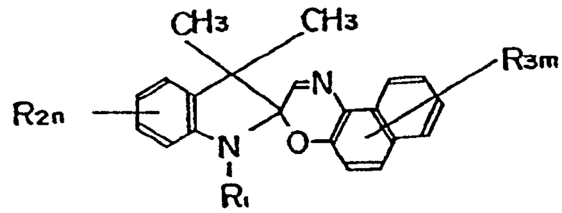 (II)

wherein $R_1$ denotes non-substituted or substituted alkyl group having a number of contained carbon of 1 - 22; $R_2$ and $R_3$ each denotes substituent selected out of hydrogen atom, alkyl group, alkoxyl group, aryl group, hydroxyl group, amino group, halogen group, cyano group, carboxyl group, nitro group and the like; and m and n denote integers in a range of 0 - 5.

Organic additive for use in the first layer may preferably be selected out of:

(1) compound such as represented by phenol derivatives, bisphenol derivatives, phenolphthaleine, thymolphthaleine, bisphenol-derivative containing polyether resin, and substitutives of them;

(2) compound such as aliphatic carboxylic acid such as myristic acid, palmitic acid, stearic acid, etc. and substitutives of them; compound such as aliphatic carboxylic acid salt as represented by calcium stearate, for example, and its substitutive; compound such as fatty amide as represented by stearic acid amide, for example, and its substitutive; and

(3) sensitizer exciting triplet state compound as represented by benzophenone, Michler's ketone, naphthalene, anthracene, anthraquinone, thioxanthone, etc. and substitutives of them.

It is not always a requisition that only one of them is used.

It is considered that these compounds have a function of (i) depressing sub-reaction of photochemical reaction, (ii) stabilizing color material to suppress decoloring reaction and the like, and it is possible to enhance the color developability, the repetition durability and the preservation stability of the photochromic material.

Examples of polymer usable in the first layer are those polymeric materials (polymeric resin materials) such as polymethylmethacrylate, polycarbonate, polystyrene, polybutylmethacrylate, etc., having high transparency in ultraviolet and visible ranges.

Particularly, polymethylmethacrylate is preferable since it shows highest transparency and thus good resolution in read-out of a positioning pattern marked on a dummy wafer.

Examples of organic solvent usable in the first layer are those having low volatility with a boiling point not lower than 100 °C, such as toluene, xylene, dioxane, cyclohexanone, cyclopentanone, butyl acetate, propyl acetate, methyl benzoate, methyl lactate, ethyl cellosolve acetate, n-butyl cellosolve acetate, diethylenglycolmonomethylacetate, diacetonealcohol, methylisobutylketone.

The total concentration of solid component of the photochromic material, the organic additive and the polymer in the coating liquid for the first layer, may preferably be in the range of 1 - 40 weight % of the whole quantity of coating liquid. If it is less than 1 weight %, the viscosity of the coating liquid is too small and it is difficult to obtain with the coating process a sufficient film thickness for attaining desired color developability. If it is higher than 40 weight %, the viscosity of the coating liquid is too large and the coating property degrades and, thus, formation of a thin film is difficult to achieve.

The content of photochromic material in the first layer is preferably in the range of 5 - 80 weight % of the whole quantity of first layer. If it is less than 5 weight %, the concentration of the photochromic material is too low, and desired color developability is not obtainable. If it is higher than 80 weight %, the concentration of the

photochromic material is too high, and it can not be solved in the above-described organic solvent for the first layer or, if solved, it is crystallized in the film, after coating, and becomes non-transparent. More desirably, the content may be in the range of 20 - 60 weight %.

The content of organic additive is preferably in the range of 0.1 - 50 weight % of the whole quantity of first layer. If it if less than 0.1 weight %, the effect of additive is too small, and desired color developability is not obtainable. If it is higher than 50 weight %, the mechanical strength of the coating film (first layer) is low, resulting in a possibility of film crack or peeling. More desirably, the content is in the range of 1 - 10 weight %.

As for the coating method, in consideration of conveniences in the silicon wafer coating, a spin coat method (drop-and-spin coat method) is desirable.

The thickness of the first layer is preferably 0.1 - 5 microns and, more preferably, 0.3 - 2 microns. If it is smaller than 0.1 micron, the concentration of photochromic material is too low, and desired contrast is not obtainable for observation from the above. If it is larger than 5 microns, the contrast is high but there is a possibility that, since a stepper or the like usually has a depth of focus, to a resist, of only about 1 micron, the linewidth of a mark when printed by marking exposure becomes blurred.

Examples of polymer usable in the second layer are those polymeric materials (polymeric resin materials) such as polyvinylalcohol, partial soaponificating material of polyvinylacetate, cellulose, polyacrylonitrile, polyvinylidenechloride, nylon and the like, copolymer or blend of them, copolymer of one of vinyl monomers, constituting them, with another polymerizable monomer.

The film thickness of the second layer is preferably 0.1 - 2 microns. If it is smaller than 0.1 micron, desired oxygen blocking property is not obtainable. If it is larger than 2 microns, there is a high possibility of defocus in marking exposure due to a difference in refractive index between the first and second layers.

Examples of solvent usable for preparation of the second layer are methylalcohol, ethylalcohol and the like.

It is to be noted here that preferably the heat-drying treatment is executed after formation of the second layer, so as to enhance the adhesive force thereof with the first layer.

These and other objects, features and advantages of the present invention will become more apparent upon a consideration of the following description of the preferred embodiments of the present invention taken in conjunction with the accompanying drawings.

## BRIEF DESCRIPTION OF THE DRAWINGS:

Figure 1 is a schematic representation showing an example of a projection exposure apparatus in which a dummy wafer according to the present invention can be incorporated.

Figure 2 is a front view of a masking member used in the Figure 1 apparatus.

## DESCRIPTION OF THE PREFERRED EMBODIMENTS

Before explaining details of a dummy wafer of the present invention, an example of step-and-repeat type projection exposure apparatus with which a dummy wafer of the present invention is usable will be explained below.

Referring to Figure 1, there is shown a projection exposure apparatus of step-and-repeat type which includes a surface plate 1 on which a wafer stage 2 is placed. The wafer stage 2 carries thereon a wafer chuck 3 on which a dummy wafer or a real wafer, denoted at 4, is held by attraction. The wafer stage 2 is movable to move the dummy wafer or real wafer 4 in a plane perpendicular to an optical axis of a projection lens system 5. The wafer stage 2 is provided with a mirror 6 which functions to reflect a laser beam from a laser interferometer (not shown), such that a well-known distance measuring system using the laser interferometer can operate to measure the position of the wafer stage 2. In accordance with a measured value, the movement of the wafer stage 2 is controlled. Disposed above the projection lens system 5 is a reticle 9 which is held by a reticle stage. As the reticle 9 is irradiated with light supplied from an illumination optical system A disposed above the reticle 9, a pattern formed on the reticle 9 is transferred through the projection lens system 5 to a photosensitive layer provided on the surface of the wafer 4.

The illumination optical system A includes a super high pressure Hg lamp 10 as well as condenser lenses 11, 12 and 13 and mirrors 14 and 15, for uniformly illuminating the reticle 9, having the pattern formed on its surface 17, with the light emanating from the lamp 10. Shutter 16 is provided to control the amount of exposure. The condenser lenses 12 and 13 and the mirror 15 function to bring the pattern bearing surface 17 of the reticle 9 into an optically conjugate or imaging relationship with a plane denoted at B. In this plane B, a masking means D is disposed. The masking means D functions to variably restrict the range of illumination of the reticle 9.

As is best seen in Figure 2, the masking means D includes a pattern illuminating mask 19 and an alignment mark illuminating mask 20 both of which are held by a frame 18. The mask 19 has a window 38 for allowing

illumination of a relatively large area of the reticle 9, which area includes a circuit pattern formed on the reticle. On the other hand, the mask 20 is provided with apertures 39 each being adapted to illuminate only a portion of the reticle 9 in which one or more aligment marks are formed. In order to selectively and detachably insert these masks 19 and 20 . into the path of illumination with the light from the lamp 10, the frame member 18 can be moved by a cylinder 21.

Disposed adjacent the projection lens system 5 is an alignment optical system C. In this alignment optical system C, light emanating from a halogen lamp 22 is concentrated by a collecting mirror 23 and a condensing lens 24 and, after passing a half prism 25, it enters into and emanates from an objective lens 26. For alignment of the wafer 4, the wafer stage 2 is moved rightwardly from the illustrated position to allow that an alignment mark provided on the wafer 4 is positioned within the viewfield of the objective lens 26. Thus, at this time, the light emanating from the objective lens 26 is reflected by the wafer 4. The reflected light from the wafer 4 goes through the objective lens 26, the half prism 25 and a relay lens 28 in the named order, such that an image of the alignment mark of the wafer 4 is formed on an image pickup surface 30 of an image pickup device 29. In response, the image pickup device 29 produces a video signal which is processed by a processing means, not shown, whereby any positional error of the alignment mark of the wafer 4 with respect to a predetermined reference set in the alignment optical system C, for example, the center of the image pickup surface 30, is detected. Thereafter, the position of the wafer 4 is adjusted so as to reduce the detected positional error to zero. Subsequently, while monitoring the position of the wafer stage 2 through the laser interferometer (not shown), the wafer stage 2 is moved exactly by a certain reference length, as described hereinbefore, which length has been determined in preparation by the positional relationship between the projection lens system 5 and the alignment optical system C and which has been memorized in a storing means (not shown) of the apparatus of Figure 1. By this, the alignment of the wafer 4 to the reticle 9 is completed. After this, while precisely controlling movement of the wafer stage 2 through the laser interferometer, images of the pattern of the reticle 9 are printed on different shot areas on the wafer 4 in a step-and-repeat manner.

As described hereinbefore, the positional relationship between the projection lens 5 and the alignment optical system C is changeable with time. Therefore, the actual reference length which is determined by the positional relationship therebetween can change with time. On the other hand, the reference length as memorized in the storing means of the apparatus in the form of data is fixed. Therefore, in order to allow accurate alignment of the wafer 4 with respect to the reticle 9, in the apparatus of Figure 1, it is necessary to correct the reference length data stored in the storing means of the apparatus by an amount corresponding to any change with time in the actual reference length, by using a dummy wafer in the manner described hereinbefore.

More specifically, the correction may be made in the following manner:

First, a dummy wafer is placed on and held by the wafer chuck 3 by attraction. Thereafter, the wafer stage 2 is positioned as illustrated. Concurrently, the cylinder 21 is actuated so as to introduce the mask 20 into the path of illumination by the illumination optical system A. After this, light from the Hg lamp 10 is supplied through the apertures 39 of the mask 20 to illuminate only the alignment mark 30 areas of the reticle 9, such that the alignment marks 30 of the reticle 9 are printed through the projection lens system 5 on the photosensitive layer provided on the dummy wafer 4. After the printing, in accordance with the reference length data stored in the storing means of the apparatus, the wafer stage 2 is moved toward the alignment optical system C. If the reference length data memorized in the storing means exactly corresponds to the actual reference length, it follows that an image of the alignment mark 30 printed on the photosensitive layer of the dummy wafer 4 is observed at the center of the image pickup surface 30 of the image pickup device 29. If, on the other hand, the actual reference length does not correspond to the reference length data of the storing means because of a change with time in the positional relationship between the projection lens system 5 and the alignment optical system C, such an image is observed at a position deviated from the center of the image pickup surface 30. Such a deviation can be detected by processing the video signal from the image pickup device 29 and, by an amount corresponding to the detected deviation, the reference length data having been memorized in the storing means of the apparatus is corrected. The corrected reference length data is used in the succeeding wafer exposure operations. Thus, it is now possible to exactly align a real wafer 4 with respect to the reticle 9, through the alignment optical system C.

The described is a method of correcting a system error by use of a dummy wafer. Next, examples of dummy wafer of the present invention, usable in such a correcting method, as well as the method of manufacture of the same will now be explained.

Example 1

First, as an organic photochromic material, ethyl cellosolve acetate solution having 18 weight % of total concentration of solid components was prepared by solving 100 parts by weight of spironaphthooxazine ($R_1$ =

$CH_3$, and $R_2 = R_3 = H$ in chemical formula (II)), 8 parts by weight of bisphenol A (organic additive) and 100 parts by weight of polymethylmethacrylate (polymeric resin) having molecular weight of 600,000, into 950 parts by weight of ethyl cellosolve acetate solvent.

By using the prepared solution of an amount of 3 g and by using a spinner, in a temperature of 25 °C a silicon wafer was coated under the conditions of 300 rpm x 10 sec (first time) and 1,500 rpm x 60 sec (second time). Thereafter, the wafer was heat-treated for 20 min in a clean oven with a set temperature of 98±2 °C, whereby a first layer was formed. The first layer (coating film) had a film thickness of 1.5 micron.

Subsequently, while completely protecting the silicon wafer having the first layer formed thereon against ultraviolet rays, it was set on a spinner and was coated by using 10 % water solution of polyvinylalcohol (having a polymerization degree of 1,000 and a soaponification degree of 99 mol %) and under the conditions of 300 rpm x 30 sec (first time) and 6,000 rpm x 60 sec (second time). After that, the wafer was heat-treated for 40 min in a clean oven with a set temperature of 98±2 °C, whereby a dummy wafer of Example 1 as having first and second layers, was obtained.

The thickness of the second layer of the dummy wafer was 1.0 micron. The polymethylmethacrylate used in the first layer had a transmission rate of oxygen of $1.15x10^{-10}$ $cm^3 \cdot cm/cm^2 \cdot s \cdot cmHg$, and the polyvinylalcohol used in the second layer had a transmission rate of oxygen of $0.0089x10^{-10}$ $cm^3 \cdot cm/cm^2 \cdot s \cdot cmHg$.

The prepared dummy wafer was irradiated with a filter-cut ultraviolet light of 365 nm from a super high pressure Hg lamp of 400 W until the color development was saturated. The saturation exposure amount was 300 $mJ/cm^2$ and the saturated absorbance was 1.7. Additionally, the color material was irradiated by an observation halogen lamp (10 $mW/cm^2$) of $\lambda max$ = 580 nm. The decay time to the saturated absorbance of 0.5 was about 30 seconds. Further, it was heat-treated at 90 °C for 3 min to cause decoloration and, additionally, the coloring/decoloring test was repeated in the same process as described until the saturated absorbance was decreased to 1.0. The result was that the number of repetitions was 120.

Example 2

In place of spironaphthooxazine, 100 parts by weight of 1,3,3-trimethylindolino-6′-nitrobenzopyrylospiran ($R_1$ = CH3, and $R_2 = R_3 = H$ in chemical formula (I)) was used and, in place of bisphenol A, 12 parts by weight of calcium stearate was used. Except for that, the same operation was made as in the formation of the first layer in Example 1, by which a first layer was formed.

While completely protecting the silicon wafer having the first layer formed thereon against ultraviolet rays, it was placed on a spinner and a second layer was formed on the wafer in the same manner as the formation of the second layer in Example 1.

The resultant dummy wafer had a saturation exposure amount of 250 $mJ/cm^2$ and a saturated absorbance of 1.9, and the decay time to the saturated absorbance of 0.5 with irradiation by the halogen lamp was 1,000 sec.

As a result of repetition of coloring/decoloring through 20 repetitions, the saturated absorbance was reduced to 1.0.

Example 3

A silicon wafer prepared in accordance with Example 2 was placed on a stage of a stepper (Canon FPA-4500), and a linear pattern of 2 micron linewidth was photoprinted on the wafer through an excimer laser light $\lambda max$ = 248 nm with exposure amount 100 $mJ/cm^2$. Subsequently, the pattern was observed through an observation microscope and displayed on a monitor. On the basis of video signals, the contrast of the exposed portion to the unexposed portion was measured. The result was 82 %. It was sufficient contrast (sensitivity) for execution of alignment precision correction in a stepper.

Comparison Example 1

In accordance with the first-layer forming method of Example 1 as described, only a first layer was formed on a silicon wafer, by which a dummy wafer of Comparison Example 1 was obtained.

By using that wafer, coloring/decoloring test was repeated as in Example 1 until the saturated absorbance reduced to 1.0 as in Example 1. The number of repetitions was 30.

Comparison Example 2

In accordance with the first-layer forming method of Example 2 as described, only a first layer was formed

on a silicon wafer, by which a dummy wafer of Comparison Example 2 was obtained.

By using that wafer, coloring/decoloring test was repeated as in example 2 until the saturated absorbance reduced to 1.0. The number of repetitions was 5.

Comparison Example 3

A dummy wafer was prepared in the same manner as of example 1, except for that dephenylthiocarbazonophenylmercury which is one of dithizone derivatives was used in place of spironaphthooxazine.

Ultraviolet light was projected in the same manner as of Example 1, but substantially no coloration was achieved and, thus, desired color developability was not obtained.

Comparison Example 4

A dummy wafer was prepared in the same manner as of Example 1, except for that: 20 parts by weight of tetrabenzopentacene which is one of condensed polycyclic compounds (in substitution for spironaphthooxazine) and 100 parts by weight of polystyrene having molecular weight of 100,000 (in substitution for polymethylmethacrylate), were solved into 500 parts by weight of toluene solvent (in substitution for ethyl cellosolve acetate).

Ultraviolet light was projected in the same manner as of Example 1. The result was that the saturated absorbance was 0.2 with saturation exposure amount of 7,000 $mJ/cm^2$. Thus, the color developability was very low.

Comparison Example 5

A dummy wafer of Comparison Example 5 was prepared in the same manner as of Example 1, except for that the first layer did not contain bisphenol A.

Ultraviolet light was projected in the same manner as of Example 1. The result was that the saturation exposure amount increased to 330 $mJ/cm^2$ as compared with Example 1 while the saturated absorbance decreased to 1.5.

Comparison Example 6

A dummy wafer of Comparison Example 6 was prepared in the same manner as of Example 2, except for that the first layer did not contain calcium stearate.

By using that wafer, ultraviolet light was projected in the same manner as of Example 1. The result was that the saturation exposure amount increased to 280 $mJ/cm^2$ as compared with Example 2 while the saturated absorbance decreased to 1.7.

With a dummy wafer of the present invention, as described hereinbefore, the following advantageous effects are provided:

(1) Photochromic material of a first layer is selected out of spiro-pyran derivatives and spironaphthooxazine derivatives, and organic additive and polymer are added. This ensures sufficient color developability to ultraviolet light. Accordingly, it is possible to execute marking exposure under substantially the same conditions as those of exposure of a resist in a semiconductor exposure apparatus such as a stepper.

This assures enhanced alignment precision without affecting the efficiency of semiconductor device manufacture.

(2) The first layer made of such derivative is overcoated with a layer (second layer) of low oxygen transmission rate. This is effective to prevent decomposition of the photochromic material and to enhance the repetition durability of it.

For this reason, it becomes possible to accomplish many marking exposures with a small number of dummy wafers and, thus, to decrease the cost for the dummy wafers. Further, the need for a large space for dummy wafer preservation can be avoided.

(3) Where 1,3,3-trimethylindolino-6′-nitrobenzopyrylospiran is used as the photochromic material of the first layer, there are additional advantages of enhanced developability and reduced cost of dummy wafer.

While the invention has been described with reference to the structures disclosed herein, it is not confined to the details set forth and this application is intended to cover such modifications or changes as may come within the purposes of the improvements or the scope of the following claims.

## Claims

1. A dummy wafer usable in a step-and-repeat type semiconductor device manufacturing exposure apparatus for moving a wafer chuck, supporting a semiconductor wafer, stepwise and printing patterns on different portions of the wafer in a step-and-repeat manner, and usable in correction of a system error of the exposure apparatus, said dummy wafer comprising:

   a substrate to be held by the wafer chuck by attraction;

   a first layer formed on the substrate and containing (a) 5 - 80 weight % of organic photochromic material selected out of spiro-pyran derivatives and spironaphthooxazine derivatives, (b) 0.1 - 50 weight % of organic additive, and (c) 20 - 94.9 weight % of polymer; and

   a second layer formed on the first layer and having a layer of polymer material with a transmission rate of oxygen not greater than $1.0 \times 10^{-10}$ $cm^3 \cdot cm/cm^2 \cdot s \cdot cmHg$;

   wherein a mark can be transferred to the first layer with use of an exposure beam used for the pattern printing onto the semiconductor wafer; and

   wherein the mark as transferred to the first layer can be observed or detected through the second layer.

2. A dummy wafer according to Claim 1, wherein the photochromic material consists of spiro-pyran derivative as represented by a general formula (I) such as follows:

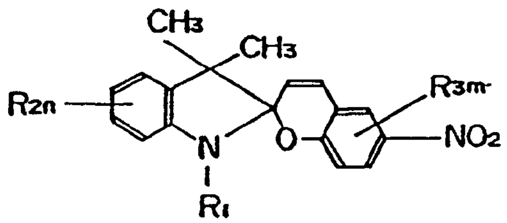

(I)

   wherein $R_1$ denotes non-substituted or substituted alkyl group having a number of contained carbon of 1 - 22; $R_2$ and $R_3$ each denotes substituent selected out of hydrogen atom, alkyl group, alkoxyl group, aryl group, hydroxyl group, amino group, halogen group, cyano group, carboxyl group, nitro group and the like; and m and n denote integers in a range of 0 - 4.

3. A dummy wafer according to Claim 1, wherein the spiro-pyran derivative is 1,3,3-trimethylindolino-6'-nitrobenzopyrylospiran.

4. A dummy wafer according to Claim 1, wherein the polymer contained in the first layer consists of polymethylmethacrylate.

5. A dummy wafer according to Claim 1, wherein the second layer contains at least one resin material consisting of polyvinylalcohol or copolymer of polyvinylalcohol with another polymer material.

6. A dummy wafer usable in a step-and-repeat type semiconductor device manufacturing exposure apparatus having an alignment mark detecting system disposed outside a path of an exposure beam and detecting an alignment mark on a semiconductor wafer held by a wafer chuck, and for moving the wafer chuck stepwise relative to the exposure beam path to print patterns on different portions of the wafer in a step-and-repeat manner with use of the exposure beam passing through the exposure beam path, said dummy wafer being usable in correction of a system error of the exposure apparatus, said dummy wafer comprising:

   a substrate to be held by the wafer chuck by attraction;

   a first layer formed on the substrate and containing (a) 5 - 80 weight % of organic photochromic material selected out of spiro-pyran derivatives and spironaphthooxazine derivatives, (b) 0.1 - 50 weight % of organic additive, and (c) 20 - 94.9 weight % of polymer; and

   a second layer formed on the first layer and having a layer of polymer material effective to protect the function of the first layer;

   wherein a mark can be transferred to the first layer from a reticle set in the exposure apparatus, with use of the exposure beam; and

   wherein the reticle mark as transferred to the first layer can be detected through the second layer by the alignment mark detecting system.

7. A dummy wafer according to Claim 6, wherein the photochromic material consists of spiro-pyran derivative as represented by a general formula (I) such as follows:

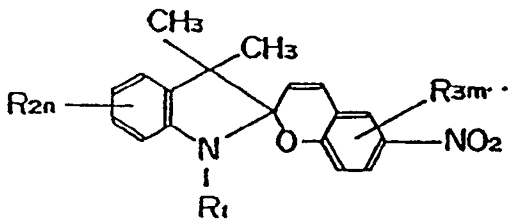

(I)

wherein $R_1$ denotes non-substituted or substituted alkyl group having a number of contained carbon of 1 - 22; $R_2$ and $R_3$ each denotes substituent selected out of hydrogen atom, alkyl group, alkoxyl group, aryl group, hydroxyl group, amino group, halogen group, cyano group, carboxyl group, nitro group and the like; and m and n denote integers in a range of 0 - 4.

8. A dummy wafer according to Claim 6, wherein the spiro-pyran derivative is 1,3,3-trimethylindolino-6′-nitrobenzopyrylospiran.

9. A dummy wafer according to Claim 6, wherein the polymer contained in the first layer consists of polymethylmethacrylate.

10. A dummy wafer according to Claim 6, wherein the second layer contains at least one resin material consisting of polyvinylalcohol or copolymer of polyvinylalcohol with another polymer material.

11. A dummy wafer usable in a step-and-repeat type exposure apparatus for manufacturing semiconductor devices to position a wafer chuck of said apparatus, the wafer comprising a substrate, a light-sensitive layer on the substrate and a layer of polymeric material which protects the light-sensitive layer and has an oxygen transmission rate of not greater than 1 x $10^{-10}cm^3$. $cm/cm^2.s.cmHg$.

12. A dummy wafer usable in a step and repeat type exposure apparatus for manufacturing semiconductor devices to position a wafer chuck of said apparatus, the wafer comprising a substrate, a light-sensitive layer on the substrate which contains an organic photochromic material which is a spiro-pyran derivative or a spironaphthooxazine derivative.

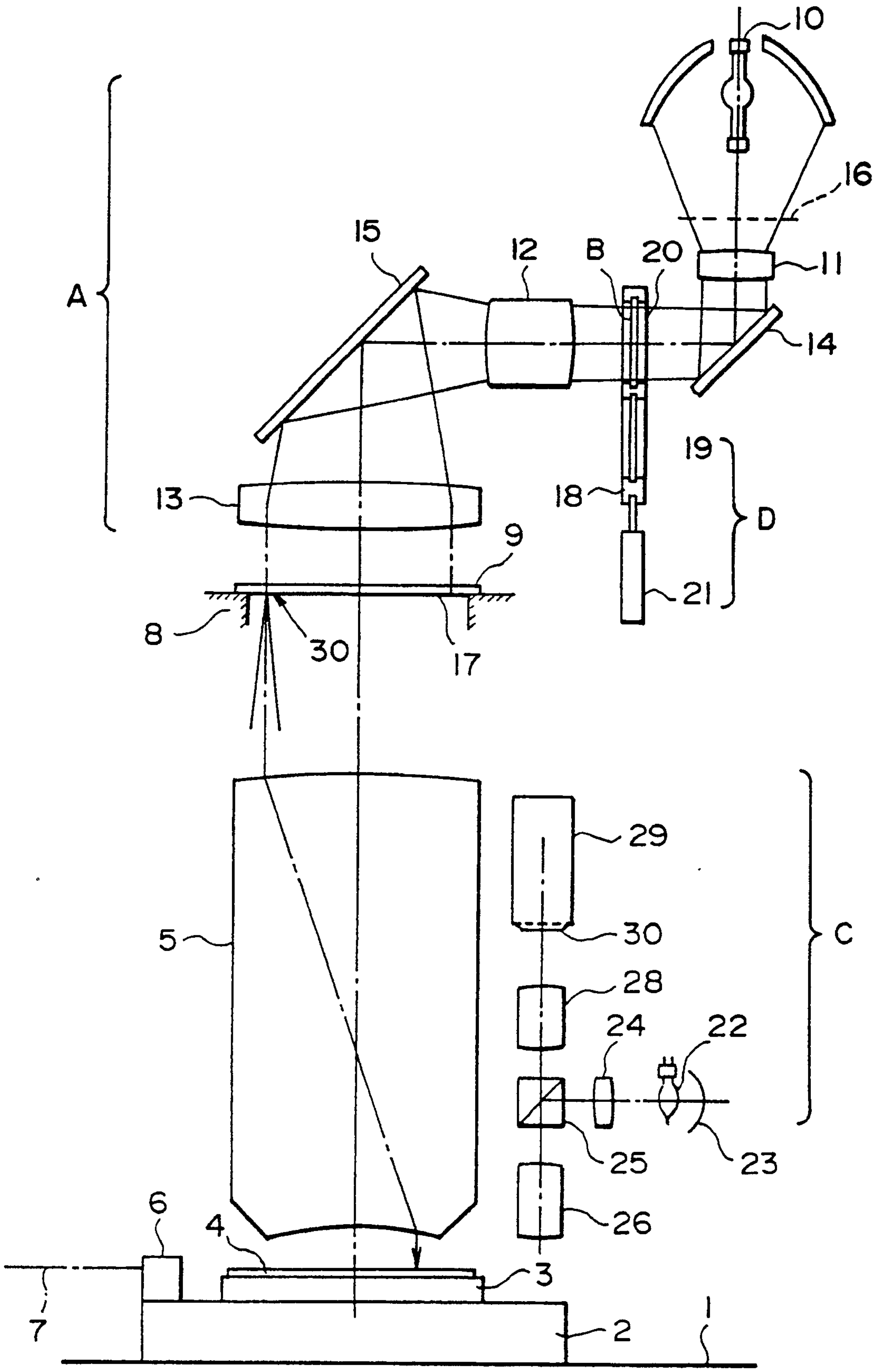
10
16
11
15
12
B
20
14
A
19
18
D
13
9
21
8
30
17
29
5
30
C
28
24
22
25
23
6
4
26
3
7
2
1

F I G. 1

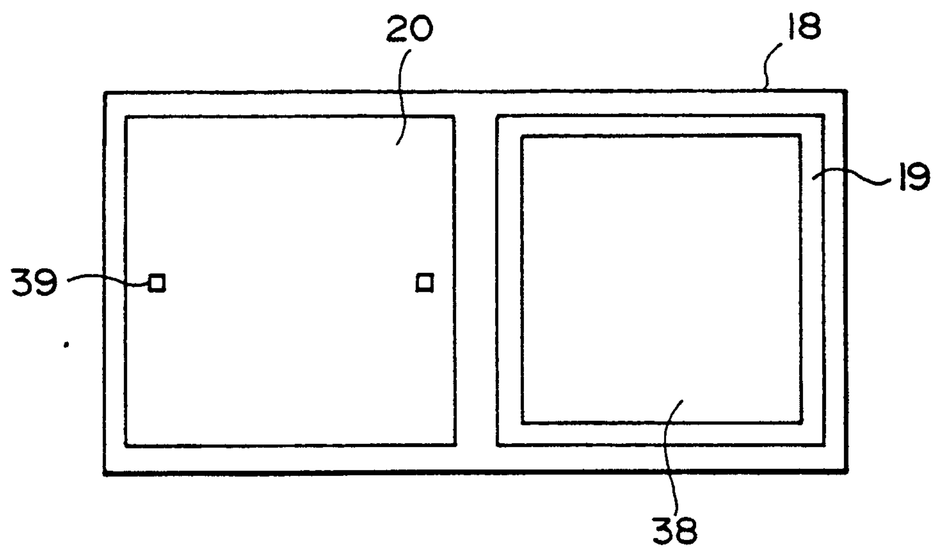


F I G. 2